# EUROPEAN PATENT APPLICATION

(11) **EP 4 683 446 A1**
(43) Date of publication of application: **21.01.2026**
(21) Application number: 25184102.9
(22) Date of filing: 20.06.2025
(51) Int. Cl.: H05K 7/20

(54) **SYSTEMS FOR COOLING MODULE WITH CONTINUOUSLY PROGRESSIVE COOLING FINS**

(30) Priority: 18.07.2024 US 202418776940
(71) Applicant: BorgWarner US Technologies LLC, Wilmington, DE 19801 (US)
(72) Inventor: CHOI, Edward, Lake Orion, MI (US); CHOI, Jeehoon, Carmel, IN (US)
(74) Representative: Office Freylinger

(57) **Abstract**

A heat sink system includes a first heat sink including: a container including a cavity; a housing connecting to the container to cover the cavity, wherein one or more of the container or the housing includes an inlet port, and one or more of the container or the housing includes an outlet port; and a cooling module in the cavity between the container and the housing, the cooling module in a flow of coolant from the inlet port to the outlet port, wherein the cooling module includes: one or more cooling fins with a fin geometry having a continuously progressive sinusoidal wave extending along the flow of the coolant from the inlet port to the outlet port.

## Description

### TECHNICAL FIELD

Various embodiments of the present disclosure relate generally to a cooling module, and more specifically, to systems for providing thermal management and continuously progressive cooling fins on a cooling module to, e.g., facilitate reducing the temperature in a power module.

### BACKGROUND

Thermal management is considered a key technical aspect in an electric vehicle system. A cooling module may therefore be a critical component in a traction inverter system, which controls the performance and efficiency of an overall driving system of an electric vehicle. However, some cooling modules may have limited capability for thermal performance optimization and may have high pressure drop.

The present disclosure is directed to overcoming one or more of these above referenced challenges.

### SUMMARY OF THE DISCLOSURE

In some aspects, the techniques described herein relate to a heat sink system including: a first heat sink including: a container including a cavity; a housing connecting to the container to cover the cavity, wherein one or more of the container or the housing includes an inlet port, and one or more of the container or the housing includes an outlet port; and a cooling module in the cavity between the container and the housing, the cooling module in a flow of coolant from the inlet port to the outlet port, wherein the cooling module includes: one or more cooling fins with a fin geometry having a continuously progressive sinusoidal wave extending along the flow of the coolant from the inlet port to the outlet port.

In some aspects, the techniques described herein relate to a heat sink system, wherein the one or more cooling fins include a cooling fin having an upstream end and a downstream end, wherein the upstream end of the cooling fin is at the inlet port of the one or more of the container or the housing, and wherein the downstream end of the cooling fin is at the outlet port of the one or more of the container or the housing.

In some aspects, the techniques described herein relate to a heat sink system, wherein the one or more cooling fins includes: a first cooling fin having a first upstream end and a first downstream end; a second cooling fin having a second upstream end and a second downstream end, and a third cooling fin having a third upstream end and a third downstream end.

In some aspects, the techniques described herein relate to a heat sink system, wherein the cooling module includes: a first transition zone between the first downstream end and the second upstream end; and a second transition zone between the second downstream end and the third upstream end, wherein the first transition zone and the second transition zone do not include cooling fins.

In some aspects, the techniques described herein relate to a heat sink system, wherein the cooling module includes: a first transition zone between the first downstream end and the second upstream end; and a second transition zone between the second downstream end and the third upstream end, wherein each of the first transition zone and the second transition zone includes one or more transition zone cooling fins with a flat fin geometry.

In some aspects, the techniques described herein relate to a heat sink system, wherein the first downstream end is connected to the second upstream end, and the second downstream end is connected to the third upstream end.

In some aspects, the techniques described herein relate to a heat sink system, further including: one or more power modules, wherein the first heat sink is provided on the one or more power modules.

In some aspects, the techniques described herein relate to a heat sink system, further including: a second heat sink, wherein the one or more power modules include: a first power module; a second power module; and a third power module, wherein the first heat sink is provided on a first side surface of the first power module, a first side surface of the second power module, and a first side surface of the third power module, and wherein the second heat sink is provided on a second side surface of the first power module, a second side surface of the second power module, and a second side surface of the third power module.

In some aspects, the techniques described herein relate to an inverter including the heat sink system.

In some aspects, the techniques described herein relate to a vehicle including the inverter.

In some aspects, the techniques described herein relate to a cooling module including: one or more cooling fins with a fin geometry having a continuously progressive sinusoidal wave extending from an upstream end to a downstream end, along a flow of coolant.

In some aspects, the techniques described herein relate to a cooling module, wherein the one or more cooling fins include a first cooling fin having a first upstream end and a first downstream end.

In some aspects, the techniques described herein relate to a cooling module, wherein the one or more cooling fins further include: a second cooling fin having a second upstream end and a second downstream end, and a third cooling fin having a third upstream end and a third downstream end.

In some aspects, the techniques described herein relate to a cooling module, further including: a first transition zone having an upstream end and a downstream end; and a second transition zone having an upstream end and a downstream end, wherein the upstream end of the first transition zone is connected with the first downstream end of the first cooling fin and the downstream end of the first transition zone is connected with the second upstream end of the second cooling fin; wherein the upstream end of the second transition zone is connected with the second downstream end of the second cooling fin and the downstream end of the second transition zone is connected with the third upstream end of the third cooling fin, and wherein the first transition zone and the second transition zone do not include cooling fins.

In some aspects, the techniques described herein relate to a cooling module, further including: a first transition zone having an upstream end and a downstream end; and a second transition zone having an upstream end and a downstream end, wherein the upstream end of the first transition zone is connected with the first downstream end of the first cooling fin and the downstream end of the first transition zone is connected with the second upstream end of the second cooling fin; wherein the upstream end of the second transition zone is connected with the second downstream end of the second cooling fin and the downstream end of the second transition zone is connected with the third upstream end of the third cooling fin, and wherein each of the first transition zone and the second transition zone include one or more transition zone cooling fins with a flat fin geometry.

In some aspects, the techniques described herein relate to a cooling module, wherein the second cooling fin is arranged upstream of the third cooling fin and the first cooling fin is arranged upstream of the second cooling fin.

In some aspects, the techniques described herein relate to a cooling module, wherein a wavelength of the continuously progressive sinusoidal wave at the downstream end of the one or more cooling fins is shorter than a wavelength of the continuously progressive sinusoidal wave at the upstream end of the one or more cooling fins.

In some aspects, the techniques described herein relate to a system including: an inverter configured to convert DC power from a battery to AC power to drive a motor, wherein the inverter includes: one or more power modules; and a first heat sink configured to extract heat from the one or more power modules, wherein the first heat sink includes: a first container including a first cavity; a first housing connecting to the first container to cover the first cavity, wherein one or more of the first container or the first housing includes a first inlet port, and one or more of the first container or the first housing includes a first outlet port; and a first cooling module in the first cavity between the first container and the first housing, the first cooling module in a first flow of coolant from the first inlet port to the first outlet port, wherein the first cooling module includes: one or more cooling fins with a fin geometry having a continuously progressive sinusoidal wave extending from an upstream end to a downstream end, along the first flow of the coolant from the first inlet port to the first outlet port.

In some aspects, the techniques described herein relate to a system, wherein the one or more cooling fins include: a first cooling fin having a first upstream end and a first downstream end; a second cooling fin having a second upstream end and a second downstream end; and a third cooling fin having a third upstream end and a third downstream end, wherein a wavelength of the continuously progressive sinusoidal wave at the first downstream end of the first cooling fin, the second downstream end of the second cooling fin, and the third downstream end of the third cooling fin has a first length, wherein a wavelength of the continuously progressive sinusoidal wave at the first upstream end of the first cooling fin, the second upstream end of the second cooling fin, and the third upstream end of the third cooling fin has a second length, and wherein the first length is from approximately 10% to approximately 90% of the second length.

In some aspects, the techniques described herein relate to a system, further including: a second heat sink, wherein the first heat sink is provided on a first side surface of the one or more power modules, and wherein the second heat sink is provided on a second side surface of the one or more power modules.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a traction inverter, according to one or more embodiments.
FIG. 2 depicts an exploded view of an exemplary heat sink system including a cooling module, according to one or more embodiments.
FIG. 3 depicts a top view of an exemplary heat sink system including a cooling module with cooling fins, according to one or more embodiments.
FIG. 4 depicts a top view of an exemplary heat sink system including a cooling module with cooling fins and transition regions without fins, according to one or more embodiments.
FIG. 5 depicts a top view of an exemplary heat sink system including a cooling module with cooling fins and transition regions including fins, according to one or more embodiments.
FIG. 6 depicts a top view of an exemplary heat sink system including a cooling module with multiple zones of cooling fins, according to one or more embodiments.
FIG. 7A depicts an exemplary cooling assembly including a first heat sink and a power module, according to one or more embodiments.
FIG. 7B depicts the cooling assembly of FIG. 7A and including a second heat sink, according to one or more embodiments.
FIG. 8 depicts an exemplary three-phase double-side cooling assembly including a plurality of power modules, according to one or more embodiments.
FIG. 9 is a side view of the three-phase double-side cooling assembly 800 of FIG. 8 with a single direction coolant flow path, according to one or more embodiments.
FIG. 10 is a side view of the three-phase double-side cooling assembly 800 of FIG. 8 with a dual direction coolant flow path, according to one or more embodiments.
FIG. 11 is a top view of an exemplary three-phase heat sink system, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the power module may be described as a device, but may refer to any device for controlling the flow of power in an electrical circuit. For example, a power module may be a metal-oxide-semiconductor field-effect transistor (MOSFETs), bipolar junction transistor (BJTs), insulated-gate bipolar transistor (IGBTs), or relays, for example, or any combination thereof, but are not limited thereto.

Thermal management may be considered a key technical aspect in an electric vehicle system. A cooling module may therefore be a critical component in a traction inverter system, which controls the performance and efficiency of an overall driving system of an electric vehicle. Therefore, improved thermal management with high performance cooling modules may be a demanding technology for performance and reliability of traction inverters. However, some cooling modules may have limited capability for thermal performance optimization and may have high pressure drop. Some cooling modules with single-side or double-side cooled power modules may have power modules operating at high temperatures, may not provide a well-balanced thermal performance among power modules due to coolant heat-up effect along a coolant flow direction, and may not provide a low pressure drop due to the cooling fin design.

One or more embodiments may include cooling fins which may have continuously progressively changing wavelength (waviness) of the fins in a flow direction of coolant. One or more embodiments may reduce pressure drop in an inverter, which may result in a parasitic loss reduction of a cooling system by reducing the energy consumption of the coolant pump. One or more embodiments may reduce the temperature of a power module, which may result in a higher performance or power density of the inverter, or a longer driving range of an electric vehicle. One or more embodiments may include continuously progressive cooling fins that may provide uniform temperature among power modules, which may improve the performance and reliability of an electric vehicle.

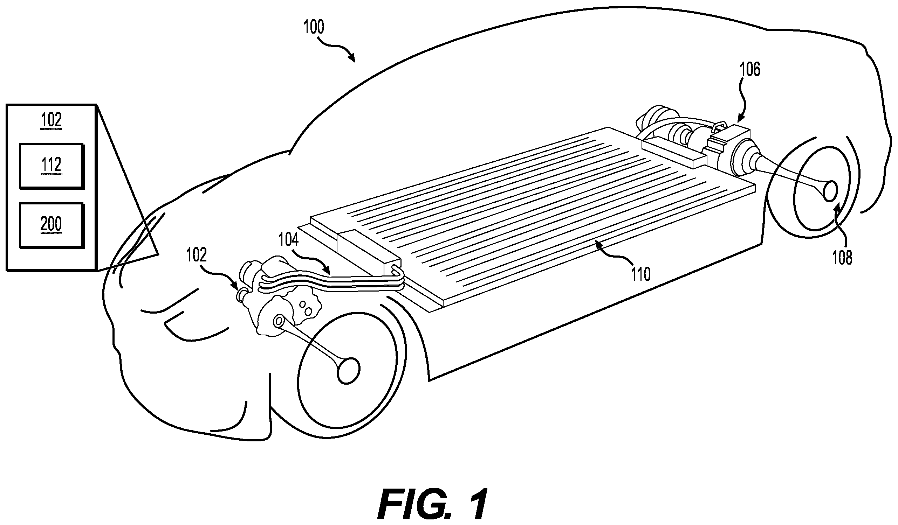

FIG. 1 depicts an exemplary system infrastructure for a vehicle including a traction inverter, according to one or more embodiments. Electric vehicle 100 may include traction inverter 102, connectors 104, drive motor 106, wheels 108, and battery 110. Traction inverter 102 may include power module 112 and heat sink system 200. Heat sink system 200 may be used to cool power module 112. Connectors 104 may connect the traction inverter 102 and battery 110. Traction inverter 102 may include components to receive electrical power from an external source and output electrical power to charge battery 110 of electric vehicle 100. Traction inverter 102, through the use of a power module 112, may convert DC power from battery 110 in electric vehicle 100 to AC power, to power the drive motor 106 and wheels 108 of electric vehicle 100, for example, but the embodiments are not limited thereto. The traction inverter 102 may be bidirectional, and may convert DC power to AC power, or convert AC power to DC power, such as during regenerative braking, for example. Traction inverter 102 may be a single-phase inverter, or a multi-phase inverter, such as a three-phase inverter, for example.

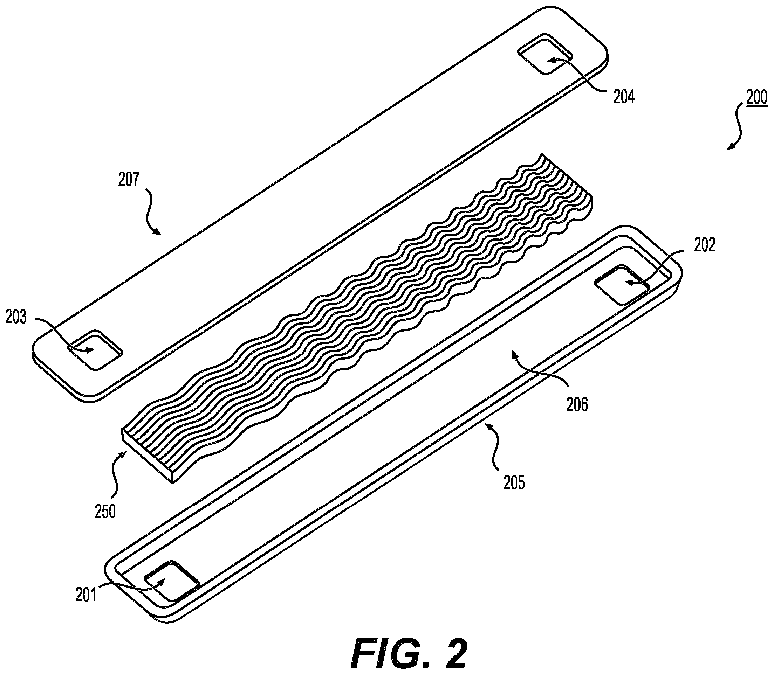

FIG. 2 depicts an exploded view of an exemplary heat sink system including a cooling module, according to one or more embodiments. Heat sink system 200 may include a housing 207, a container 205, and a cooling module 250. The housing 207 may include an inlet port 203 and an outlet port 204. The container 205 may include an inlet port 201, an outlet port 202, and a cavity 206.

The cooling module 250 may be provided between the housing 207 and the container 205. The housing 207 may be in contact with the cooling module 250. The container 205 may be in contact with the cooling module 250. The container 205 may include the cavity 206 where the cooling module 250 may be provided. The inlet port 203 of the housing 207 or the inlet port 201 of the container 205 may be configured to supply a refrigerant (e.g. liquid coolant) to the cavity 206 and the cooling module 250. The outlet port 204 of the housing 207 or the outlet port 202 of the container 205 may be configured to exhaust the refrigerant (e.g., liquid coolant) from the cavity 206 and the cooling module 250.

The heat sink system 200 may include the housing 207 having the inlet port 203 and the outlet port 204, and the container 205 having the inlet port 201 and the outlet port 202, but embodiments are not limited thereto. For example, in one or more embodiments, the housing 207 may not include the inlet port 203 and/or the outlet port 204, and/or the container 205 may not include the inlet port 201 and/or the outlet port 202.

The heat sink system 200 may be configured to provide thermal heat dissipation to (e.g., extract heat from) the power module 112 (e.g., see FIG. 1). A material of the housing 207 and the container 205 of the heat sink system 200 may be selected based on a required thermal performance needed to extract heat from the power module 112. For example, the housing 207 and the container 205 of the heat sink system 200 may include an aluminum alloy having a high thermal conductivity, but embodiments are not limited thereto. For example, the housing 207 and the container 205 of the heat sink system 200 may include copper, but embodiments are not limited thereto. The refrigerant used in the heat sink system 200 may include a circulating fluid of liquid (e.g., liquid coolant) or gas therein, but embodiments are not limited thereto. The heat sink system 200 may be provided in an extruded, folded fin, bonded fin, active fan, stamping, or cross-cut configuration, but embodiments are not limited thereto.

The cooling module 250 may be a continuous, single-folded, metal sheet having a rectangular, circular, or curved geometry, but embodiments are not limited thereto. Similar to the housing 207 and the container 205 of the heat sink system 200, the cooling module 250 may include an aluminum alloy having a high thermal conductivity while being mechanically soft, but embodiments are not limited thereto. The cooling module 250 may include copper, or an alloy of copper and aluminum, for example, but embodiments are not limited thereto.

The cooling module 250 may have cooling fins having an upstream end and a downstream end arranged along a flow of coolant from the inlet ports 201/203 to the outlet ports 202/204. For example, the cooling module 250 may be provided in the cavity 206 with the cooling fins having the upstream end at the inlet port 201 of the container 205 and the downstream end at the outlet port 202 of the container 205, but embodiments are not limited thereto.

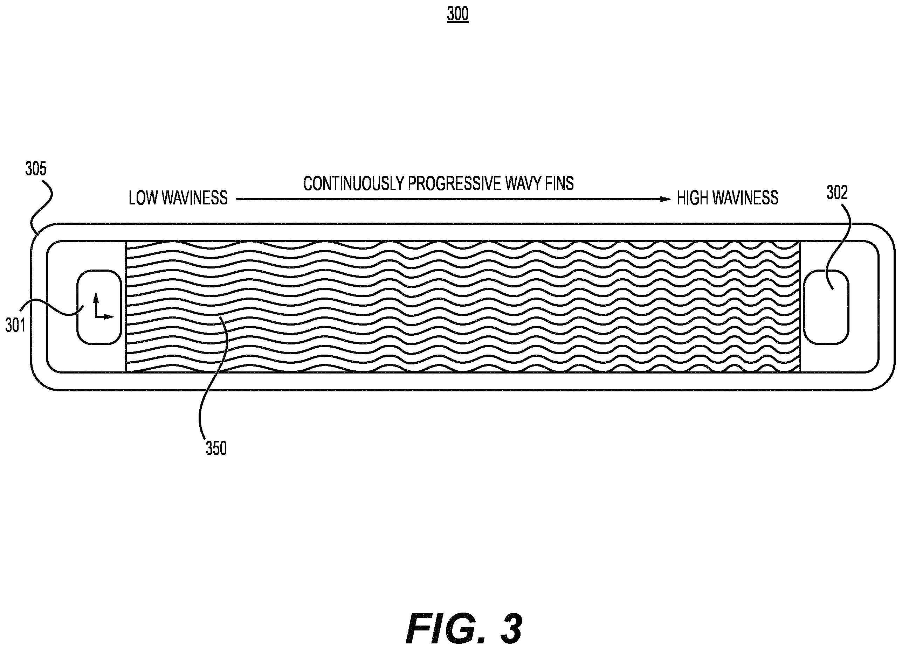

FIG. 3 depicts a top view of an exemplary heat sink system including a cooling module with cooling fins, according to one or more embodiments. Heat sink system 300 may include a container 305, an inlet port 301, an outlet port 302, and a cooling module 350 having cooling fins with an upstream end at the inlet port 301 and a downstream end at the outlet port 302. With reference to FIG. 2, the container 305 may correspond to the container 205, the inlet port 301 may correspond to the inlet port 201, the outlet port 302 may correspond to the outlet port 202, and the cooling module 350 may correspond to the cooling module 250. The cooling module 350 may be provided in a cavity (not shown in FIG. 3) of the container 305. For brevity, the heat sink system 300 of FIG. 3 and the heat sink system 200 of FIG. 2 may contain many similarities which will not be discussed.

The cooling module 350 may include cooling fins with a fin geometry having a continuously progressive sinusoidal wave extending from an upstream end of the cooling fin to a downstream end of the cooling fin. For example, a wavelength of the continuously progressive sinusoidal wave at the downstream end of the cooling fins may be shorter (e.g., high waviness or more wavy) than a wavelength of the continuously progressive sinusoidal wave at the upstream end of the cooling fins (e.g., low waviness or less wavy). For example, the wavelength of the continuously progressive sinusoidal wave at the downstream end of the cooling fins may be from approximately 10% to approximately 50% of the wavelength of the continuously progressive sinusoidal wave at the upstream end of the cooling fins, but embodiments are not limited thereto. For example, the wavelength of the continuously progressive sinusoidal wave at the downstream end of the cooling fins may be from approximately 10% to approximately 90% of the wavelength of the continuously progressive sinusoidal wave at the upstream end of the cooling fins, but embodiments are not limited thereto.

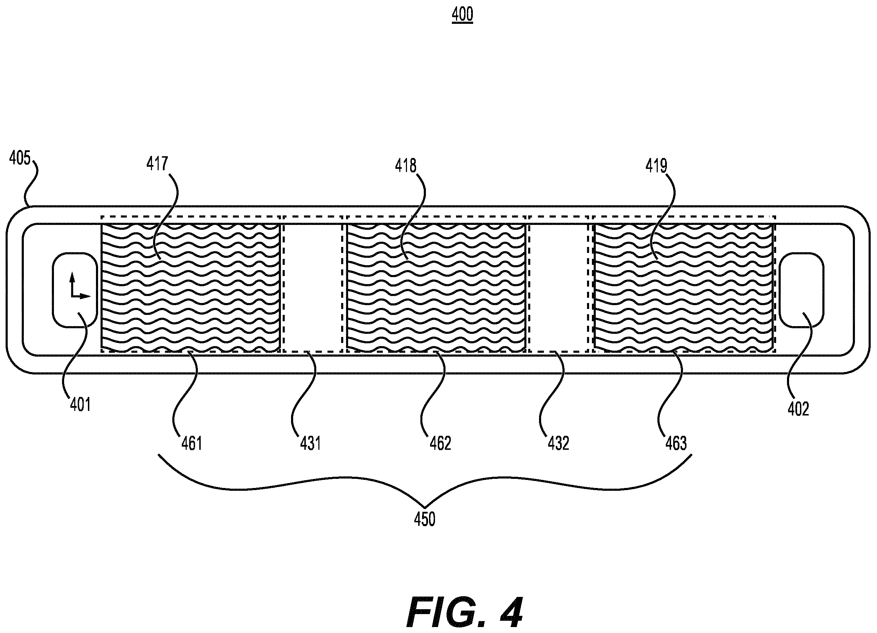

FIG. 4 depicts a top view of an exemplary heat sink system including a cooling module with cooling fins and transition regions without fins, according to one or more embodiments. Heat sink system 400 may include a container 405, an inlet port 401, an outlet port 402, and a cooling module 450. The cooling module 450 may be provided in a cavity (not shown in FIG. 4) of the container 405. The cooling module 450 may include a first cooling zone 461, a second cooling zone 462, a third cooling zone 463, a first transition zone 431, and a second transition zone 432. For brevity, the heat sink system 400 of FIG. 4 and the heat sink system 300 of FIG. 3 may contain many similarities which will not be discussed. For brevity of description, only distinctions between the heat sink system 400 and the heat sink system 300 will be described.

The first cooling zone 461 may include a first cooling fin 417. The first cooling fin 417 may include an upstream end and a downstream end. The first cooling fin 417 may include a fin geometry having a continuously progressive sinusoidal wave extending from an upstream end of the first cooling fin 417 to a downstream end of the first cooling fin 417. For example, a wavelength of the continuously progressive sinusoidal wave at the downstream end of the first cooling fin 417 may be shorter (e.g., high waviness or more wavy) than a wavelength of the continuously progressive sinusoidal wave at the upstream end of the first cooling fin 417 (e.g., low waviness or less wavy).

The second cooling zone 462 may include second cooling fin 418. The second cooling fin 418 may include an upstream end and a downstream end. The second cooling fin 418 may include a fin geometry having a continuously progressive sinusoidal wave extending from an upstream end of the second cooling fin 418 to a downstream end of the second cooling fin 418. For example, a wavelength of the continuously progressive sinusoidal wave at the downstream end of the second cooling fin 418 may be shorter (e.g., high waviness or more wavy) than a wavelength of the continuously progressive sinusoidal wave at the upstream end of the second cooling fin 418 (e.g., low waviness or less wavy).

The third cooling zone 463 may include third cooling fin 419. The third cooling fin 419 may include an upstream end and a downstream end. The third cooling fin 419 may include a fin geometry having a continuously progressive sinusoidal wave extending from an upstream end of the third cooling fin 419 to a downstream end of the third cooling fin 419. For example, a wavelength of the continuously progressive sinusoidal wave at the downstream end of the third cooling fin 419 may be shorter (e.g., high waviness or more wavy) than a wavelength of the continuously progressive sinusoidal wave at the upstream end of the third cooling fin 419 (e.g., low waviness or less wavy).

The first cooling fin 417, the second cooling fin 418, and the third cooling fin 419 may differ from one another in one or more of number, thickness, height in a direction transverse to coolant flow (e.g., an "amplitude" of waviness of the cooling fin), length in a direction of coolant flow, pitch, spacing, or material composition. For example, the first cooling fin 417 in first cooling zone 461 may be composed of copper, while second cooling fin 418 in the second cooling zone 462 may be composed of aluminum, but embodiments are not limited thereto. Each of the first cooling fin 417, the second cooling fin 418, and the third cooling fin 419 may be composed of one or more materials. For example, the first cooling fin 417 may include a first portion composed of copper and a second portion composed of aluminum, or a combination of aluminum and copper, but embodiments are not limited thereto. For example, each of the first cooling fin 417, the second cooling fin 418, and the third cooling fin 419 may be composed of cooper, but embodiments are not limited thereto. For example, each of the first cooling fin 417, the second cooling fin 418, and the third cooling fin 419 may be composed of aluminum, but embodiments are not limited thereto. Although FIG. 4 depicts the cooling module 450 with three cooling zones (e.g., the first cooling zone 461, the second cooling zone 462, and the third cooling zone 463), the cooling module 450 may include one or more cooling zones. For example, cooling module 450 may include five or more cooling zones.

The first transition zone 431 may not include cooling fins. The first transition zone 431 may include an upstream end and a downstream end. The first transition zone 431 may be arranged between the first cooling zone 461 and the second cooling zone 462 such that the upstream end of the first transition zone 431 is connected to (or in contact with) a downstream end of the first cooling zone 461, and the downstream end of the first transition zone 431 is connected to (or in contact with) an upstream end of the second cooling zone 462, but embodiments are not limited thereto.

The second transition zone 432 may not include cooling fins. The second transition zone 432 may include an upstream end and a downstream end. The second transition zone 432 may be arranged between the second cooling zone 462 and the third cooling zone 463 such that the upstream end of the second transition zone 432 is connected to (or in contact with) a downstream end of the second cooling zone 462, and the downstream end of the second transition zone 432 is connected to (or in contact with) an upstream end of the third cooling zone 463, but embodiments are not limited thereto.

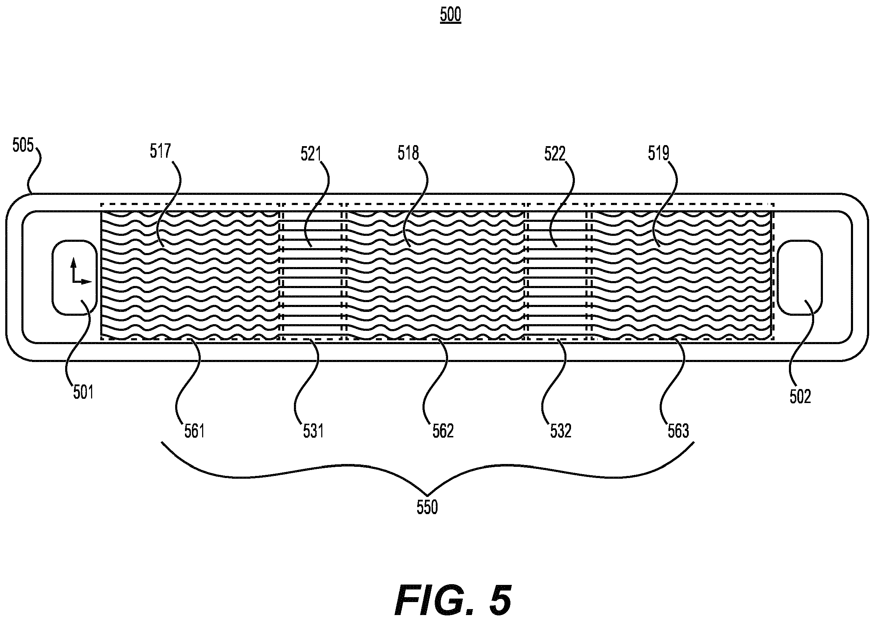

FIG. 5 depicts a top view of an exemplary heat sink system including a cooling module with cooling fins and transition regions including fins, according to one or more embodiments. Heat sink system 500 may include a container 505, an inlet port 501, an outlet port 502, and a cooling module 550. The cooling module 550 may be provided in a cavity (not shown in FIG. 5) of the container 505. The cooling module 550 may include a first cooling zone 561 having first cooling fin 517, a second cooling zone 562 having second cooling fin 518, a third cooling zone 563 having third cooling fin 519, a first transition zone 531, and a second transition zone 532. For brevity, the heat sink system 500 of FIG. 5 and the heat sink system 400 of FIG. 4 may contain many similarities which will not be discussed. For brevity of description, only distinctions between the heat sink system 500 and the heat sink system 400 will be described.

The first transition zone 531 may include a first transition zone cooling fin 521 with a flat fin geometry having a flat wave (or substantially flat wave, or a straight fin geometry) corresponding to an infinite wavelength (or a large radius geometry, for example). The first transition zone 531 may include an upstream end and a downstream end. The first transition zone 531 may be arranged between the first cooling zone 561 and the second cooling zone 562 such that the upstream end of the first transition zone 531 is connected to (or in contact with) a downstream end of the first cooling zone 561, and the downstream end of the first transition zone 531 is connected to (or in contact with) an upstream end of the second cooling zone 562.

The second transition zone 532 may include a second transition zone cooling fin 522 with a flat fin geometry having a flat wave (or substantially flat wave) corresponding to an infinite wavelength. The second transition zone 532 may include an upstream end and a downstream end. The second transition zone 532 may be arranged between the second cooling zone 562 and the third cooling zone 563 such that the upstream end of the second transition zone 532 is connected to (or in contact with) a downstream end of the second cooling zone 562, and the downstream end of the second transition zone 532 is connected to (or in contact with) an upstream end of the third cooling zone 563.

The transition zone cooling fins of the first transition zone 531 and the second transition zone 532 may each have a flat fin geometry having a flat wave (or substantially flat wave) corresponding to an infinite wavelength, but embodiments are not limited thereto.

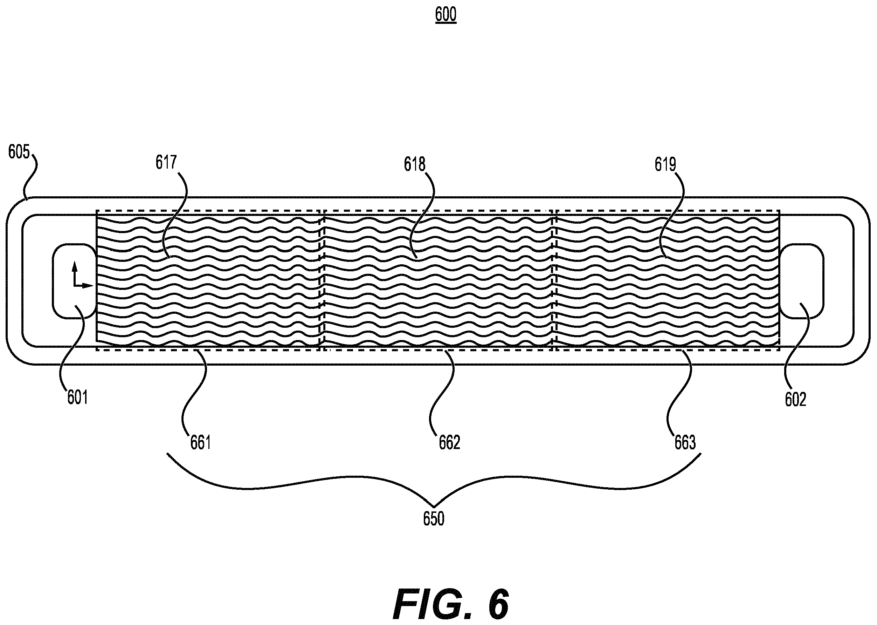

FIG. 6 depicts a top view of an exemplary heat sink system including a cooling module with cooling fins, according to one or more embodiments. Heat sink system 600 may include a container 605, an inlet port 601, an outlet port 602, and a cooling module 650. The cooling module 650 may be provided in a cavity (not shown in FIG. 6) of the container 605. The cooling module 650 may include a first cooling zone 661 having first cooling fin 617, a second cooling zone 662 having second cooling fin 618, and a third cooling zone 663 having third cooling fin 619. The cooling module 650 may not include transition zones. For brevity, the heat sink system 600 of FIG. 6 and the heat sink system 400 of FIG. 4 may contain many similarities which will not be discussed. For brevity of description, only distinctions between the heat sink system 600 and the heat sink system 400 will be described.

The third cooling fin 619 may be provided in the container 605 at the outlet port 602, at a downstream position in the container 605 in a direction of the flow of coolant. The first cooling fin 617 may be provided in the container 605 at the inlet port 601, upstream of the flow of coolant. The second cooling fin 618 may be provided in the container 605, upstream of the third cooling fin 619, and downstream of the first cooling fin 617. In other words, the second cooling fin 618 may be provided between the first cooling fin 617 and the third cooling fin 619 such that the downstream end of the first cooling fin 617 may be connected to (or in contact with) the upstream end of the second cooling fin 618, and the downstream end of the second cooling fin 618 may be connected to (or in contact with) the upstream end of the third cooling fin 619.

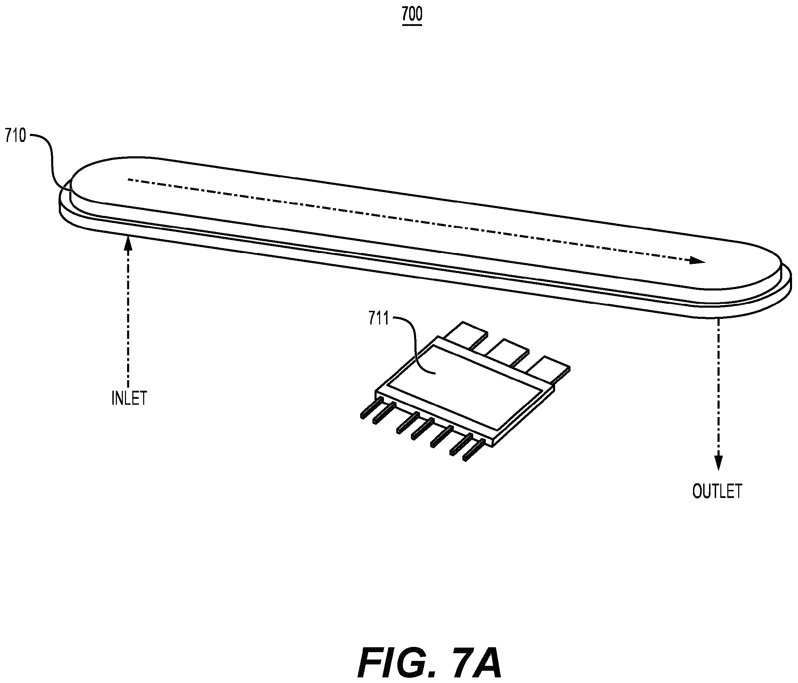

FIG. 7A depicts an exemplary cooling assembly including a first heat sink and a power module, according to one or more embodiments. Single-side cooling assembly 700 may include a first heat sink system 710 and a power module 711. The first heat sink system 710 may correspond to the heat sink system 300 of FIG. 3, the heat sink system 400 of FIG. 4, the heat sink system 500 of FIG. 5, and/or the heat sink system 600 of FIG. 6, and the power module 711 may correspond to the power module 112 of FIG. 1.

The first heat sink system 710 may include an inlet port and an outlet port (not shown in FIG. 7A). The inlet port may be configured to supply (or introduce) a flow of coolant to the first heat sink system 710 and the outlet port may be configured to exhaust the flow of coolant in the first heat sink system 710, which is depicted by the arrows in FIG. 7A.

The power module 711 has a first side surface and a second side surface. In one or more embodiments, the first heat sink system 710 may be configured to be provided on the first side surface or the second side surface of the power module 711 (e.g., on a single side surface) to extract heat from the power module 711.

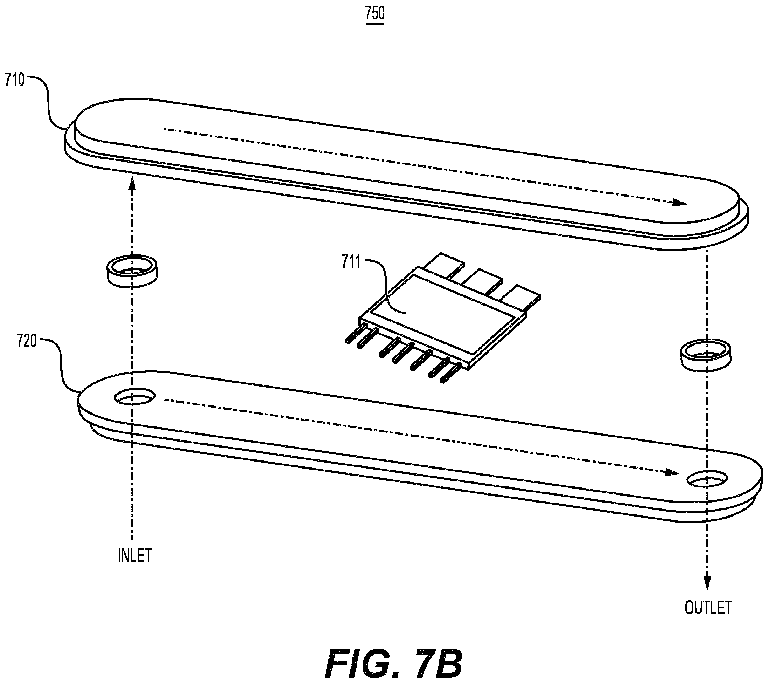

FIG. 7B depicts the cooling assembly of FIG. 7A including a second heat sink system, according to one or more embodiments. Double-side cooling assembly 750 may include the first heat sink system 710, a second heat sink system 720, and the power module 711. The first heat sink system 710 and the second heat sink system 720 may each correspond to the heat sink system 300 of FIG. 3, the heat sink system 400 of FIG. 4, the heat sink system 500 of FIG. 5, and/or the heat sink system 600 of FIG. 6, and the power module 711 may correspond to the power module 112 of FIG. 1.

The first heat sink system 710 may include an inlet port and an outlet port (not shown in FIG. 7B). The inlet port may be configured to supply (or introduce) a flow of coolant to the first heat sink system 710 and the outlet port may be configured to exhaust the flow of coolant in the first heat sink system 710, which is depicted by the arrows in FIG. 7B.

The second heat sink system 720 may include an inlet port and an outlet port (not shown in FIG. 7B). The inlet port may be configured to supply (or introduce) a flow of coolant to the second heat sink system 720 and the outlet port may be configured to exhaust the flow of coolant in the second heat sink system 720, which is depicted by the arrows in FIG. 7B.

The flow of coolant supplied into the first heat sink system 710 may be supplied from the inlet port of the second heat sink system 720, but embodiments are not limited thereto. The flow of coolant exhausted through the outlet port of the first heat sink system 710 may be exhausted to the outlet port of the second heat sink system 720, and the outlet port of the second heat sink system 720 may exhaust the flow of coolant exhausted by the first heat sink system 710 and the flow of coolant in the second heat sink system 720, but embodiments are not limited thereto.

The power module 711 has a first side surface and a second side surface. In one or more embodiments, the first heat sink system 710 may be configured to be provided on a first side surface of the power module 711 and the second heat sink system 720 may be configured to be provided on a second side surface of the power module 711 to extract heat from the power module 711.

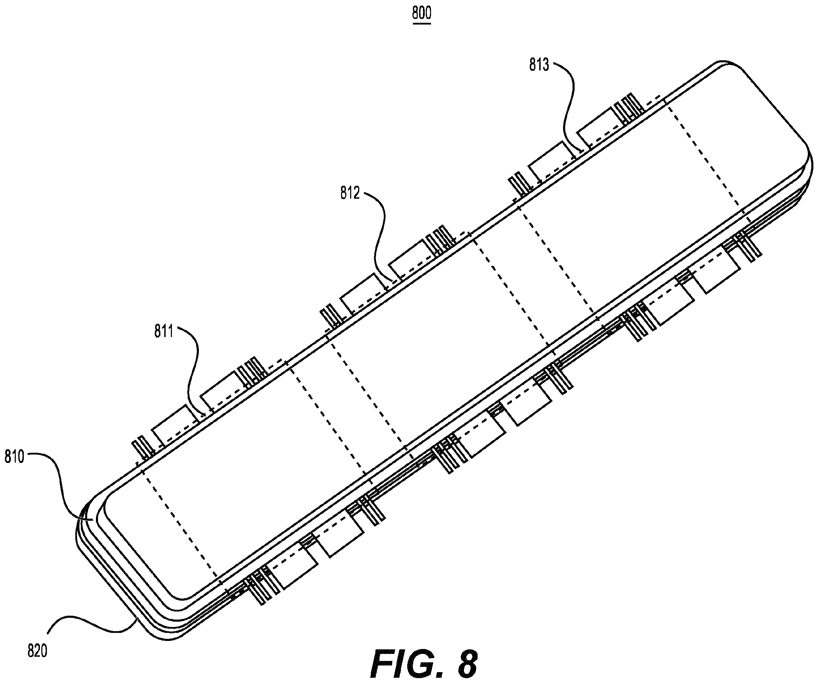

FIG. 8 depicts an exemplary three-phase double-side cooling assembly including a plurality of power modules, according to one or more embodiments. Three-phase double-side cooling assembly 800 may include a first heat sink system 810, a second heat sink system 820, and a plurality of power modules including a first power module 811, a second power module 812, and a third power module 813. The first heat sink system 810 and the second heat sink system 820 may each be the heat sink system 300 of FIG. 3, the heat sink system 400 of FIG. 4, the heat sink system 500 of FIG. 5, and/or the heat sink system 600 of FIG. 6. The plurality of power modules may correspond to power module 112 of FIG. 1. For brevity, the three-phase double-side cooling assembly 800 of FIG. 8 and the double-side cooling assembly 750 in FIG. 7B may contain many similarities which will not be discussed. For brevity of description, only distinctions between the three-phase double-side cooling assembly 800 and the double-side cooling assembly 750 will be described.

The plurality of power modules including the first power module 811, the second power module 812, and the third power modules 813, may correspond to the power module 112 of FIG. 1. For example, the power module 112 may be a three-phase power module for a three-phase system. That is, in a three-phase system, the first power module 811 may correspond to ΦA, the second power module 812 may correspond to ΦB, and the third power module 813 may correspond to ΦC.

The first power module 811, the second power module 812, and the third power module 813 may each have a first side surface and a second side surface. The first heat sink system 810 may be provided on the first side surface of the first power module 811, the first side surface of the second power module 812, and the first side surface of the third power module 813. The second heat sink system 720 may be provided on the second side surface of the first power module 811, the second side surface of the second power module 812, and the second side surface of the third power module 813. That is, the three-phase double-side cooling assembly 800 may be configured to extract heat from both side surfaces of the plurality of power modules.

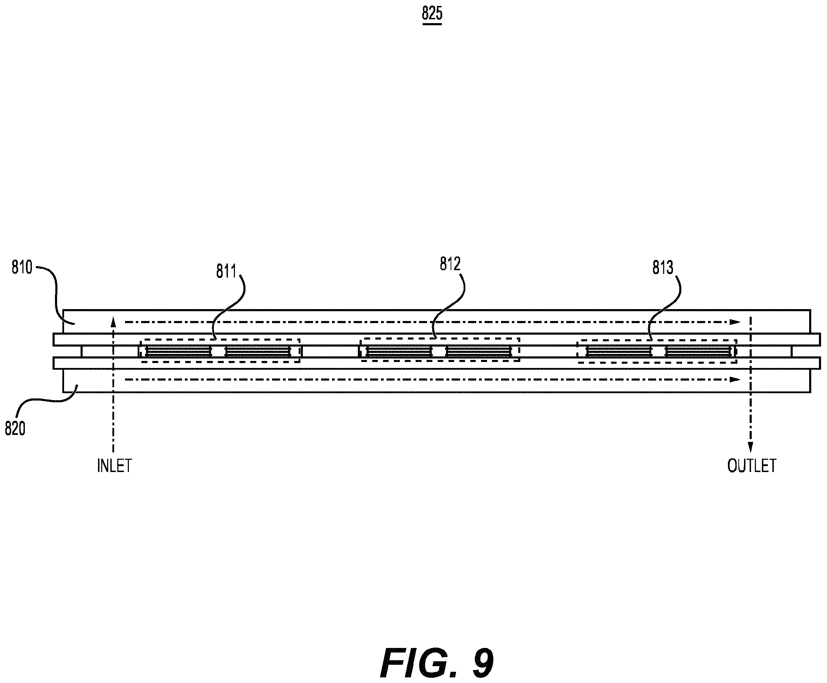

FIG. 9 is a side view of a first arrangement of the three-phase double-side cooling assembly 800 of FIG. 8, according to one or more embodiments. The first heat sink system 810 and the second heat sink system 820 may be arranged in a first arrangement 825. The first heat sink system 810 may be on the second heat sink system 820 such that the inlet port of the first heat sink system 810 and the inlet port of the second heat sink system 820 may overlap in a first direction (e.g., vertical direction), but embodiments are not limited thereto. Similarly, the outlet port of the first heat sink system 810 and the outlet port of the second heat sink system 820 may overlap in the first direction (e.g., the vertical direction), but embodiments are not limited thereto.

The inlet port of the first heat sink system 810 may be connected to the inlet port of the second heat sink system 820 such that a flow of coolant may flow from the first heat sink system 810 to the second heat sink system 820 and vice-versa. The outlet port of the first heat sink system 810 may be connected to the outlet port of the second heat sink system 820 such that a flow of coolant may flow from the first heat sink system 810 to the second heat sink system 820 and vice-versa.

Arrows in FIG. 9 may represent the flow of coolant through the three-phase double-side cooling assembly 800 in the first arrangement 825. The first heat sink system 810 and the second heat sink system 820 may be arranged in a first arrangement 825 such that coolant may be introduced (or supplied) to the second heat sink system 820 through the inlet port of the second heat sink system 820, the coolant may flow in a downstream direction (e.g., from the inlet port to the outlet port), and the coolant may be exhausted from inside the second heat sink system 820 to outside the second heat sink system 820 through the outlet port of the second heat sink system 820.

At a same time, the coolant being introduced (or supplied) to the second heat sink system 820 may also be introduced (or supplied) to the first heat sink system 810 through the connection between the inlet port of the first heat sink system 810 and the inlet port of the second heat sink system 820. The coolant in the first heat sink system 810 may flow in a downstream direction (e.g., from the inlet port to the outlet port), and the coolant may be exhausted from inside the first heat sink system 810 to the second heat sink system 820 through the connection between the outlet port of the first heat sink system 810 and the outlet port of the second heat sink system 820. The coolant exhausted from the first heat sink system 810 to the second heat sink system 820 may then be exhausted outside the second heat sink system 820, along with the coolant inside the second heat sink system 820, through the outlet port of the second heat sink system 820.

In the first arrangement 825 depicted in FIG. 9, a cooling module (not shown in FIG. 9) inside the first heat sink system 810 and a cooling module (not shown in FIG. 9) inside the second heat sink system 820 may be arranged in a same upstream to downstream direction, along the flow of the coolant depicted by the arrows in FIG. 9.

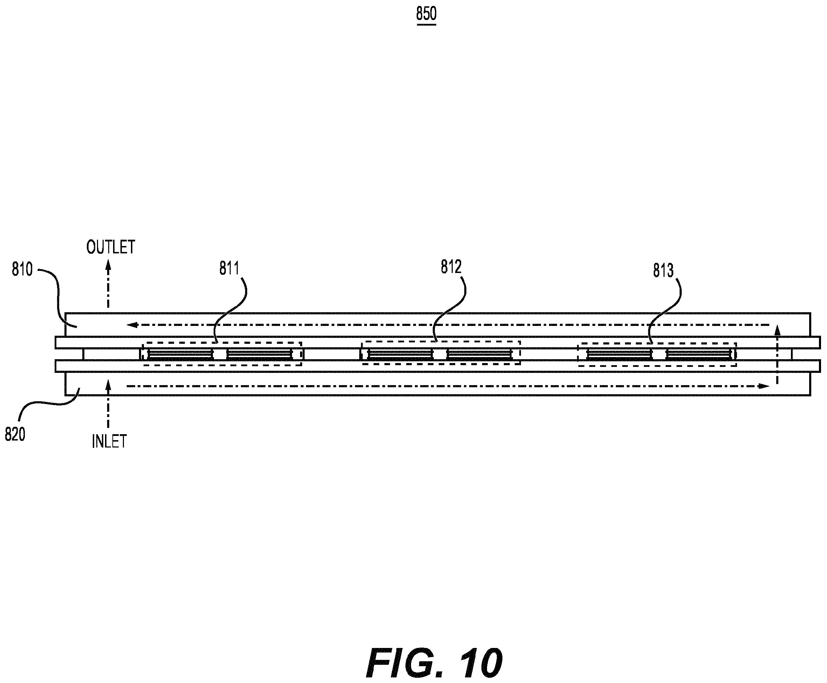

FIG. 10 is a side view of a second arrangement of the three-phase double-side cooling assembly 800 of FIG. 8, according to one or more embodiments. For brevity, the second arrangement 850 of FIG. 10 and the first arrangement 825 of FIG. 9 may contain many similarities which will not be discussed. For brevity of description, only distinctions between the second arrangement 850 and the first arrangement 825 will be described.

The first heat sink system 810 and the second heat sink system 820 may be arranged in a second arrangement 850. The first heat sink system 810 may be on the second heat sink system 820 such that the inlet port of the first heat sink system 810 and the outlet port of the second heat sink system 820 may overlap in a first direction (e.g., vertical direction), but embodiments are not limited thereto. Similarly, the outlet port of the first heat sink system 810 and the inlet port of the second heat sink system 820 may overlap in the first direction (e.g., the vertical direction), but embodiments are not limited thereto.

The inlet port of the first heat sink system 810 may be connected to the outlet port of the second heat sink system 820 such that a flow of coolant may flow from the first heat sink system 810 to the second heat sink system 820 and vice-versa. The outlet port of the first heat sink system 810 may not be connected to the inlet port of the second heat sink system 820 such that no flow of coolant can flow from the outlet port of the first heat sink system 810 to the inlet port of the second heat sink system 820.

Arrows in FIG. 10 may represent the flow of coolant through the three-phase double-side cooling assembly 800 in the second arrangement 850. The first heat sink system 810 and the second heat sink system 820 may be arranged in a second arrangement 850 such that coolant may be introduced (or supplied) to the second heat sink system 820 through the inlet port of the second heat sink system 820, the coolant may flow in a downstream direction (e.g., from the inlet port to the outlet port of the second heat sink system 820), the coolant may then flow from the second heat sink system 820 to the first heat sink system 810 through the connection between the outlet port of the second heat sink system 820 and the inlet port of the first heat sink system 810. The coolant may then flow in a downstream direction (e.g., from the inlet port to the outlet port of the first heat sink system 810), and the coolant may then be exhausted from the first heat sink system 810 to outside the first heat sink system 810 through the outlet port of the first heat sink system 810.

In the second arrangement 850 depicted in FIG. 10, a cooling module (not shown in FIG. 10) inside the first heat sink system 810 and a cooling module (not shown in FIG. 10) inside the second heat sink system 820 may be arranged in opposite upstream to downstream directions, along the flow of the coolant in each of the first heat sink system 810 and the second heat sink system 820, as depicted by the arrows in FIG. 10.

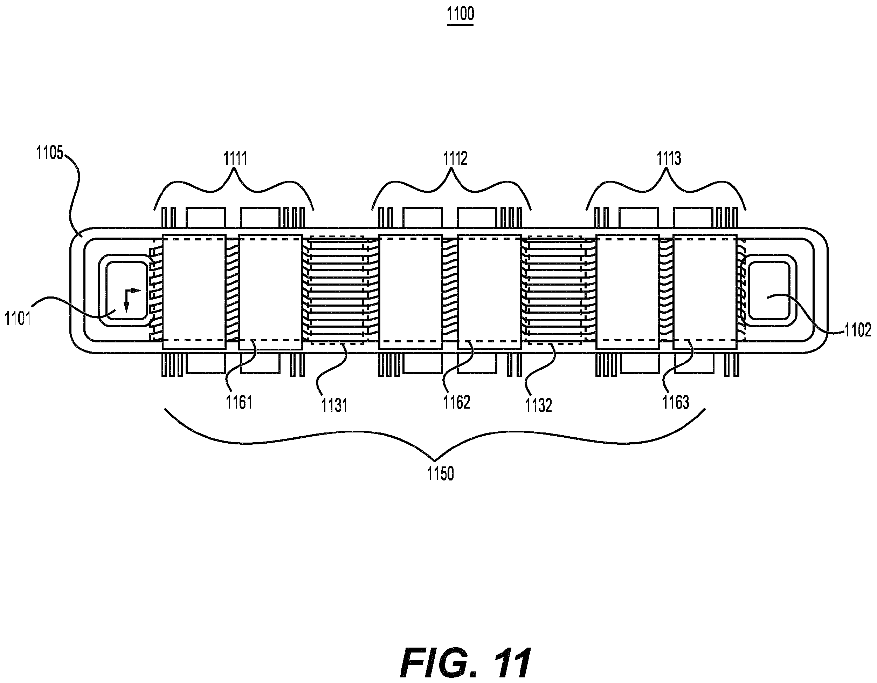

FIG. 11 depicts a top view of an exemplary three-phase heat sink system, according to one or more embodiments. Three-phase heat sink system 1100 may include a container 1105, an inlet port 1101, an outlet port 1102, a cooling module 1150, and a plurality of power modules including a first power module 1111, a second power module 1112, and a third power module 1113. The cooling module 1150 may be provided in a cavity (not shown in FIG. 11) of the container 1105. The cooling module 1150 may include a first cooling zone 1161, a second cooling zone 1162, a third cooling zone 1163, a first transition zone 1131, and a second transition zone 1132. For brevity, the three-phase heat sink system 1100 of FIG. 11 and the heat sink system 500 of FIG. 5 may contain many similarities which will not be discussed. For brevity of description, only distinctions between the three-phase heat sink system 1100 and the heat sink system 500 will be described.

The three-phase heat sink system 1100 may have the first power module 1111 provided in the first cooling zone 1161, the second power module 1112 provided in the second cooling zone 1162, and the third power module 1113 provided in the third cooling zone 1163. The three-phase heat sink system 1100 may be configured to extract heat from the first power module 1111, the second power module 1112, and the third power module 1113.

The first transition zone 1131 and the second transition zone 1132 may each include transition zone cooling fins with a flat fin geometry having a flat wave (or substantially flat wave) corresponding to an infinite wavelength, but embodiments are not limited thereto. For example, the flat fin geometry may have an inclined flat wave (or substantially inclined flat wave), but embodiments are not limited thereto. For example the flat fin geometry may have a flat wave inclined relative to a general direction of coolant flowing from the inlet port 1101 to the outlet port 1102, but embodiments are not limited thereto. For example, the first transition zone 1131 and the second transition zone 1132 may not include cooling fins, but embodiments are not limited thereto. The three-phase heat sink system 1100 may not include the first transition zone 1131 and the second transition zone 1132, but embodiments are not limited thereto. For example, the three-phase heat sink system 1100 may only include the first cooling zone 1161, the second cooling zone 1162, and the third cooling zone 1163.

According to one or more embodiments, cooling modules having cooling fins with a continuously progressive sinusoidal wave may provide a uniform temperature distribution for one or more power modules. The continuously progressive sinusoidal wave fins may reduce a pressure drop in one or more power modules and may result in parasitic loss reduction of heat sink systems, which may ultimately result in longer drive range of electric vehicles.

According to one or more embodiments, cooling modules may include cooling fins which may have continuously progressively sinusoidal waves with changing wavelengths (waviness) of the fins in a flow direction of coolant, which may reduce pressure drop in an inverter, which may result in a parasitic loss reduction of a cooling system by reducing the energy consumption of the coolant pump. Cooling modules with cooling fins having continuously progressively sinusoidal waves with changing wavelengths (waviness) of the fins in a flow direction of coolant may also help improve heat transfer in the direction of the flow of the coolant.

Accordingly to one or more embodiments, heat sink systems with cooling modules having cooling fins with a continuously progressive sinusoidal wave may reduce the temperature of one or more power modules, which may result in a higher performance or power density of the inverter, and/or a longer driving range of an electric vehicle, and/or may provide uniform temperature among one or more power modules, which may improve the performance and reliability of an electric vehicle.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A heat sink system comprising:
a first heat sink including:
a container including a cavity;
a housing connecting to the container to cover the cavity, wherein one or
more of the container or the housing includes an inlet port, and one or more of the container or the housing includes an outlet port; and
a cooling module in the cavity between the container and the housing, the cooling module in a flow of coolant from the inlet port to the outlet port,
wherein the cooling module includes one or more cooling fins with a fin geometry having a continuously progressive sinusoidal wave extending along the flow of the coolant from the inlet port to the outlet port.

2. The heat sink system of claim 1, wherein the one or more cooling fins include a cooling fin having an upstream end and a downstream end,
wherein the upstream end of the cooling fin is at the inlet port of the one or more of the container or the housing, and
wherein the downstream end of the cooling fin is at the outlet port of the one or more of the container or the housing.

3. The heat sink system of any one of claims 1 to 2, wherein the one or more cooling fins includes:
a first cooling fin having a first upstream end and a first downstream end;
a second cooling fin having a second upstream end and a second downstream end, and
a third cooling fin having a third upstream end and a third downstream end.

4. The heat sink system of claim 3,
wherein the cooling module includes:
a first transition zone between the first downstream end and the second upstream end; and
a second transition zone between the second downstream end and the third upstream end,
wherein the first transition zone and the second transition zone do not include cooling fins;
or wherein the cooling module includes:
a first transition zone between the first downstream end and the second upstream end; and
a second transition zone between the second downstream end and the third upstream end,
wherein each of the first transition zone and the second transition zone includes one or more transition zone cooling fins with a flat fin geometry;
or wherein the first downstream end is connected to the second upstream end, and the second downstream end is connected to the third upstream end.

5. The heat sink system of claims 1 to 4, further comprising:
one or more power modules, wherein the first heat sink is provided on the one or more power modules;
and preferably further comprising:
a second heat sink,
wherein the one or more power modules include:
a first power module;
a second power module; and
a third power module,
wherein the first heat sink is provided on a first side surface of the first power module, a first side surface of the second power module, and a first side surface of the third power module, and
wherein the second heat sink is provided on a second side surface of the first power module, a second side surface of the second power module, and a second side surface of the third power module.

6. An inverter comprising the heat sink system of claim 1.

7. A vehicle comprising the inverter of claim 6.

8. A cooling module comprising:
one or more cooling fins with a fin geometry having a continuously progressive sinusoidal wave extending from an upstream end to a downstream end, along a flow of coolant.

9. The cooling module of claim 8, wherein the one or more cooling fins include a first cooling fin having a first upstream end and a first downstream end.

10. The cooling module of any one of claims 8 to 9, wherein the one or more cooling fins further include:
a second cooling fin having a second upstream end and a second downstream end, and
a third cooling fin having a third upstream end and a third downstream end.

11. The cooling module of claim 10, further comprising:
a first transition zone having an upstream end and a downstream end; and
a second transition zone having an upstream end and a downstream end,
wherein the upstream end of the first transition zone is connected with the first downstream end of the first cooling fin and the downstream end of the first transition zone is connected with the second upstream end of the second cooling fin;
wherein the upstream end of the second transition zone is connected with the second downstream end of the second cooling fin and the downstream end of the second transition zone is connected with the third upstream end of the third cooling fin, and
wherein the first transition zone and the second transition zone do not
include cooling fins;
or further comprising:
a first transition zone having an upstream end and a downstream end; and a second transition zone having an upstream end and a downstream end,
wherein the upstream end of the first transition zone is connected with the first downstream end of the first cooling fin and the downstream end of the first transition zone is connected with the second upstream end of the second cooling fin;
wherein the upstream end of the second transition zone is connected with the second downstream end of the second cooling fin and the downstream end of the second transition zone is connected with the third upstream end of the third cooling fin, and
wherein each of the first transition zone and the second transition zone include one or more transition zone cooling fins with a flat fin geometry;
or wherein the second cooling fin is arranged upstream of the third cooling fin and the first cooling fin is arranged upstream of the second cooling fin.

12. The cooling module of any one of claims 8 to 11, wherein a wavelength of the continuously progressive sinusoidal wave at the downstream end of the one or more cooling fins is shorter than a wavelength of the continuously progressive sinusoidal wave at the upstream end of the one or more cooling fins.

13. A system comprising:
an inverter configured to convert DC power from a battery to AC power to drive a motor, wherein the inverter includes:
one or more power modules; and
a first heat sink configured to extract heat from the one or more power modules, wherein the first heat sink includes:
a first container including a first cavity;
a first housing connecting to the first container to cover the first cavity, wherein one or more of the first container or the first housing includes a first inlet port, and one or more of the first container or the first housing includes a first outlet port; and
a first cooling module in the first cavity between the first container and the first housing, the first cooling module in a first flow of coolant from the first inlet port to the first outlet port, wherein the first cooling module includes:
one or more cooling fins with a fin geometry having a continuously progressive sinusoidal wave extending from an upstream end to a downstream end, along the first flow of the coolant from the first inlet port to the first outlet port.

14. The system of claim 13, wherein the one or more cooling fins include:
a first cooling fin having a first upstream end and a first downstream end;
a second cooling fin having a second upstream end and a second downstream end; and
a third cooling fin having a third upstream end and a third downstream end,
wherein a wavelength of the continuously progressive sinusoidal wave at the first downstream end of the first cooling fin, the second downstream end of the second cooling fin, and the third downstream end of the third cooling fin has a first length,
wherein a wavelength of the continuously progressive sinusoidal wave at the first upstream end of the first cooling fin, the second upstream end of the second cooling fin, and the third upstream end of the third cooling fin has a second length, and
wherein the first length is from approximately 10% to approximately 90% of the second length.

15. The system of claim 13 or 14, further comprising:
a second heat sink,
wherein the first heat sink is provided on a first side surface of the one or more power modules, and
wherein the second heat sink is provided on a second side surface of the one or more power modules.
